# EUROPEAN PATENT SPECIFICATION

(11) **EP 0 794 534 B1**
(45) Date of publication and mention of the grant of the patent: **24.10.2001**
(21) Application number: 97102621.6
(22) Date of filing: 19.02.1997
(51) Int. Cl.: G11C 11/406

(54) **Refreshing of DRAM memory banks**
Auffrischung von DRAM-Speicherbanken
Régénération de bancs de mémoire DRAM

(30) Priority: 06.03.1996 FI 961040
(43) Date of publication of application: 10.09.1997
(73) Proprietor: NOKIA TECHNOLOGY GmbH, 75175 Pforzheim (DE)
(72) Inventor: Hiltunen, Reino, 25250 Märynummi (FI)
(74) Representative: Brax, Matti Juhani

(56) References cited:
- EP-A- 0 631 288
- US-A- 4 725 987
- VOLK A: "Dynamic RAM controller performance/cost tradeoffs" COMPUTER DESIGN, MARCH 1979, USA, vol. 18, no. 3, pages 127-136, XP002086045 ISSN 0010-4566

## Description

The invention relates to organising the refreshing of DRAM memory circuits, more particularly to organising the refreshing of circuits in a situation where a device, which is designed to support two memory banks, is used to refresh three or even more memory banks.

DRAM memory circuits are inexpensive, and their storage cells are simple in structure and small in size, which means that with DRAM technology, memory circuits with very high capacities can be produced. DRAM circuits are often grouped into so-called memory banks, in which case the DRAM circuits are provided on separate small printed circuit boards, which are attached to the circuit board of the equipment by means of a separate connector. The DRAM memory banks can also contain one microcircuit only, in which case the apparatus includes one ore more empty sockets for additional memory. This enables a later extension of memory capacity along with a continuous, intensive reduction in the prices of DRAM memories and an increase in their capacity.

The reading and writing of DRAM circuits takes place as follows. The address of a storage location is divided into two parts, and the first part, the row address, is first transferred to the DRAM circuit, and a RAS' (Row Address Strobe) signal is given. Thereafter the second part, the column address, is transferred to the DRAM circuit, and a CAS' (Column Address Strobe) signal is given. After the CAS' signal, the DRAM circuit either reads the data or retrieves the content of the desired storage location according to the read/write (R/W') signal. The address lines contained in the DRAM circuit constitute only half of the amount needed for addressing the memory space of the whole circuit, because the address is transferred into the circuit in two parts. Moreover, for control purposes DRAM circuits also have OE' (Output Enable) and WE' (Write Enable) lines, whereby data retrieval (OE' signal) from the memory or writing (WE' signal) to the memory can be separately allowed or prevented.

Owing to the structure of DRAM (Dynamic RAM) circuits, their properties include that their data content is lost in less than a second unless the circuits are refreshed. A given storage location of a DRAM circuit is refreshed every time when the circuit receives a RAS' signal while the line address of the storage location is set in the address lines of the circuit. Thus the refreshing of the circuit could be done simply by using the memory, if it were certain that every one of the circuit row addresses is gone through before data is lost. This is, however, not the case in practical applications, but the DRAM circuits must be provided with separate refreshing, where all row addresses are gone through. A number of additional circuits is always needed for realising the refreshing mechanism.

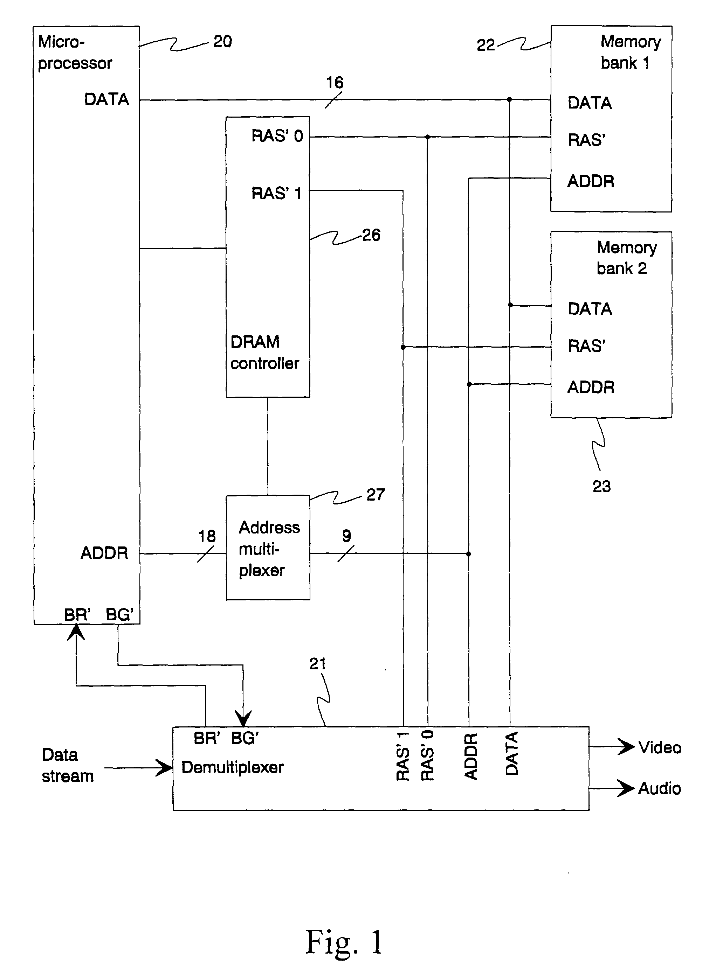

The same memory banks can well be utilised by more than one device. An example of this is shown in figure 1 illustrating a signal processing device, which breaks the incoming signal up to separate video and audio signals. The operation of the device is controlled by a microprocessor 20, but the processing proper is carried out by a demultiplexer 21. The microprocessor and the demultiplexer share the same DRAM memory 22, 23. The demultiplexer is designed to support two memory banks, wherefore it has two RAS' outputs for the memory banks. The demultiplexer also takes care of refreshing the memory banks. The microprocessor needs memory for recording program code, tables etc., whereas the demultiplexer needs memory for storing audio and video data. The microprocessor and the demultiplexer agree on the use of memory by means of the BR' (Bus Request) and BG' (Bus Grant) signals. When the demultiplexer needs memory at its disposal, the demultiplexer sets a BR' signal. When the microprocessor after that finishes its task, it indicates this by setting a BG' signal. Thereafter, the memory is at the disposal of the demultiplexer until it resets the BR' signal. As for the microprocessor, the DRAM controller 26 and the address demultiplexer 27 take care of dividing the DRAM memory addresses into two as well as of sending the RAS' and CAS' signals in the fashion described above. The demultiplexer takes care of controlling the DRAM memory circuits for its own part.

This type of structure creates a problem when another device, in case of the example the microprocessor, needs more than two memory banks, and the device performing the refreshing of the memory banks, in case of the example the demultiplexer, only supports two memory banks. Now the refreshing of the third or additional memory banks must be arranged separately which complicates the structure. The problem is how to synchronise the refreshing of the first two memory banks and the rest of the memory banks, so that they take place simultaneously; most easily this is arranged by including all memory banks to one and the same refreshing procedure.

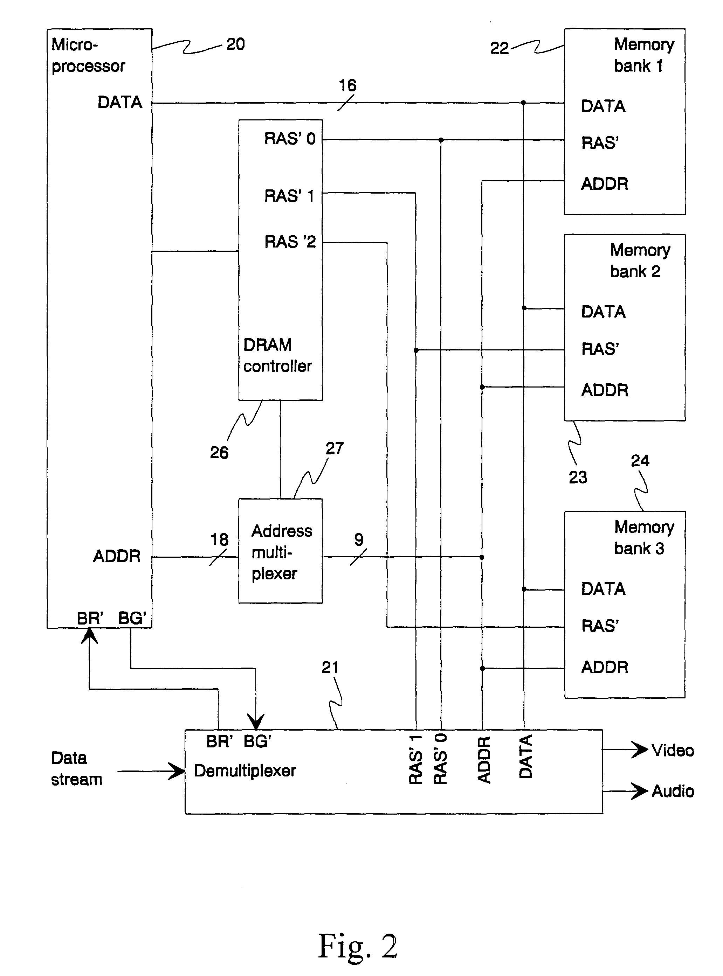

The best known solution here is to use a more complicated DRAM controller, which is able to perform the refreshing of the memory banks. Figure 2 introduces a system according to the above described example, which is realised by using this type of solution. In this case, in the exemplary apparatus, from the DRAM controller 26 there are sent three RAS' signals, one for each memory bank 22, 23, 24, and the two RAS' signals of the multiplexer 21 are coupled together with the first two RAS' signals of the DRAM controller 26. The drawback with this type of system is that the DRAM controller must be able to refresh at least one of the additional memory banks, which means that the structure of the DRAM controller gets more complicated. Consequently the number of required components increases, which slows down the fabrication process and weakens the reliability of the equipment. Moreover, the DRAM controller 26 must be provided with an oscillator required for creating the refreshing signals, which again is a possible source for radiation interference.

The object of the invention is to realise the refreshing of additional memory banks in a fashion essentially simpler than the ones used in the prior art. Another object is to reduce the number of components required for refreshing the additional memory banks. Yet another object of the invention is to arrange the refreshing of additional memory banks, so that refreshing oscillators need not be added to the system.

These objects are achieved by connecting the RAS' signals of the additional memory banks to the RAS' signals of the first, second or both memory banks, so that the demultiplexer refreshes all banks while refreshing the first two memory banks. In order to prevent the memory read and write functions of the demultiplexer from disturbing the additional memory banks, their operation must, for the duration of the use of the memory of the demultiplexer, be prevented by means of the above-mentioned OE' and WE' signals.

The invention is defined by claim 1.

The invention is explained in more detail below, with reference to the preferred embodiments described by way of example, and to the accompanying figures, where
- figure 1: illustrates a situation according to the prior art, where the system only contains two memory banks,
- figure 2: illustrates a prior art solution for connecting additional memory banks to the system, and

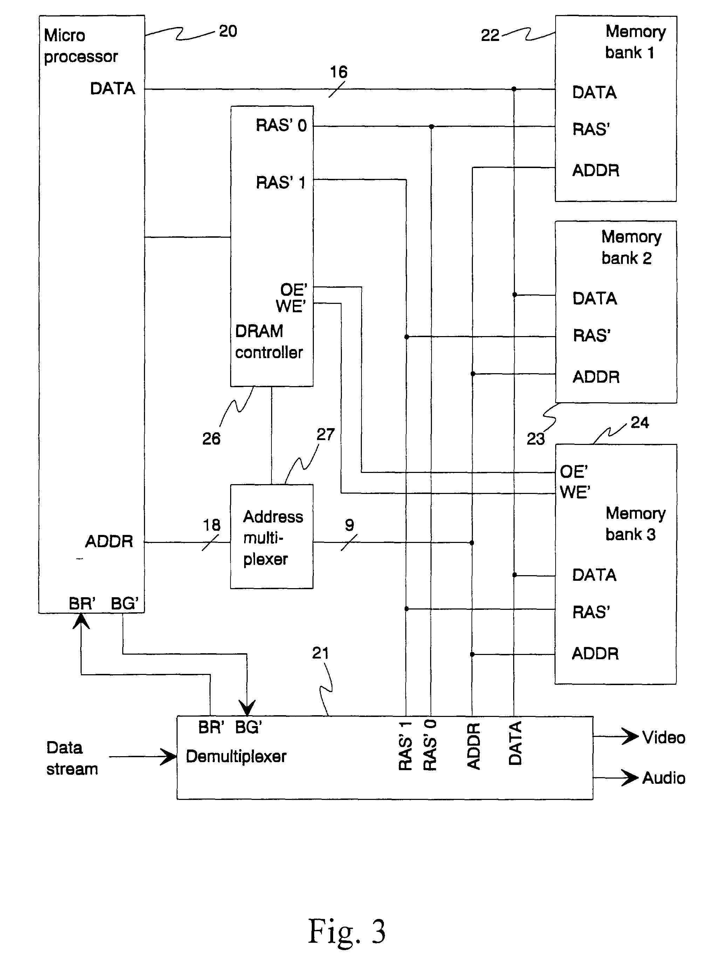

- figure 3: illustrates an arrangement according to the present invention for connecting additional memory banks to the system.

Like numbers for like parts are used in the drawings.

For the sake of clarity, all connections of the blocks are not illustrated in all blocks of the diagrams, unless they have special importance for the practical realisation of the invention.

In the system according to the invention, the problem of refreshing the additional memory banks is solved by coupling their RAS' signals together with the RAS' signals of the first or second memory bank. Now all memory banks are refreshed, when the demultiplexer refreshes two first memory banks.

Moreover, in the system of the invention the DRAM controller has been modified with respect to known technology, so that it prevents the operation of additional memory banks when the demultiplexer uses the DRAM memory. This can be realised for instance by means of the OE' and WE' signals of the DRAM memory banks. When the demultiplexer has chosen a memory at its disposal on the basis of the BR' and BG' signals, the microprocessor sets, by intermediation of the DRAM controller, the OE' and WE' signals of the additional memory banks up, so that the data recording and writing of the additional memory banks is prevented.

For example, in a preferred embodiment of the invention, a possibility for adding two additional memory banks is reserved for the system. Now the first two memory banks (basic memory banks) are always in use, and the additional memory banks are in use if they are added to the system. In that case the RAS' signal of the first additional memory bank is coupled to the RAS' signal of said first basic memory bank, and the RAS' signal of the second additional memory bank is coupled to the RAS' signal of said second basic memory bank.

It is apparent for a man skilled in the art that in the patent claims the term 'memory bank' can mean either a memory bank or a socket, a printed circuit board connector or other similar connecting means provided for a later, optional attachment of the memory bank to the system, because electronic appliances are often delivered completely or partly without memory banks, in which case the purchaser can, along with the development of memory technology, and along with the reduction in prices, himself later add to the memory capacity of the equipment.

It can be noted that from the point of view of the practical realisation of the invention, it is not necessary that the demultiplexer supports two memory banks in particular. The invention relates to extending the number of memory banks over the standard number for which the demultiplexer was originally designed. Neither is it essential from the point of view of the invention that the device using the DRAM memory apart from the microprocessor is particularly a demultiplexer. The invention relates to any device, apart from the microprocessor, that uses the DRAM memory, with limited properties in relation to the number of supported DRAM memory banks.

The different components of the system, such as the microprocessor, the DRAM memory, the DRAM controller, the demultiplexer and the address multiplexer, are means known as such for a man skilled in the art. Also the alterations needed for realising the invention in the DRAM controller with respect to the prior art are possible for a man skilled in the art even without a detailed description of the alterations.

## Claims

1. A system comprising
- a microprocessor (20);
- N+M DRAM memory banks (22, 23, 24) wherein N and M are integers larger than zero, said memory banks including a RAS' signal input for refreshing the memory bank, an OE' signal input for temporarily preventing retrieval of data from the memory bank and a WE' signal input for temporarily preventing writing of data to the memory bank;
- a DRAM controller (26) and an address multiplexer (27) for controlling the DRAM memory banks; and
- in addition to the microprocessor, second means (21) which uses the DRAM memory, said means being designed to take care of the refreshing of the DRAM memory of the system and to support N memory banks at maximum;
**characterised in that**
- the RAS' signals of the memory banks N+1 - N+M are operationally connected to the RAS' signals of the memory banks 1-N in order to enable the refreshing of the memory banks N+1 - N+M in connection with the refreshing of the memory banks 1-N, and that
- the DRAM controller is provided to prevent the operation of the memory banks N+M with the OE' and WE' signals of the DRAM memory banks while said second means using the DRAM memory is using the DRAM memory.

2. A system according to claim 1, **characterised in that** the RAS' signals of all N+1 - N+M memory banks are operationally connected to each other and to a RAS' signal of one of the memory banks 1-N.

3. A system according to claim 1, **characterised in that**
- the memory banks N+1 - N+M are divided into groups,
- within each group, the RAS' signals of the memory banks are operationally connected to each other, and
- the connected RAS' signals of each group are operationally connected to one of the RAS' signals of the memory banks 1-N, provided that the RAS' signals of said groups are connected to different memory banks 1-N.

4. A system according to any of the preceding claims, **characterised in that** N is two.

5. A system according to any of the preceding claims, **characterised in that** N is two and M is two, in which case the RAS' signal of the third memory bank is connected to the RAS' signal of the first memory bank, and the RAS' signal of the fourth memory bank is connected to the RAS' signal of the second memory bank.

## Patentansprüche

1. System mit:
- einem Mikroprozessor (20) ;
- N+M DRAM-Speicherbänken (22, 23, 24), wobei N und M ganze Zahlen über Null sind und die Speicherbänke einen RAS'-Signaleingang zum Auffrischen der Speicherbank, einen OE'-Signaleingang zum zeitweiligen Sperren des Abrufs von Daten aus der Speicherbank und einen WE'-Signaleingang zum zeitweiligen Verhindern des Einschreibens von Daten in die Speicherbank aufweisen;
- einem DRAM-Controller (26) und einem Adressenmultiplexer (27) zum Steuern der DRAM-Speicherbänke; und
- einer zweiten Einrichtung (21), zusätzlich zum Mikroprozessor, die den DRAM-Speicher verwendet, und so konzipiert ist, dass sie sich um das Auffrischen des DRAM-Speichers des Systems und maximale Unterstützung der N Speicherbänke kümmert;
**dadurch gekennzeichnet, dass**
- die Signale RAS' der Speicherbänke N+1 bis N+M funktionsmäßig mit den Signalen RAS' der Speicherbänke 1 bis N gekoppelt sind, um ein Auffrischen der Speicherbänke N+1 bis N+M in Zusammenhang mit einem Auffrischen der Speicherbänke 1 bis N zu ermöglichen; und dass
- der DRAM-Controller vorhanden ist, um Betrieb der Speicherbänke N+M mit den Signalen OE' und WE' der DRAM-Speicherbänke zu verhindern, während die zweite, den DRAM-Speicher nutzende Einrichtung diesen nutzt.

2. System nach Anspruch 1, **dadurch gekennzeichnet, dass** die Signale RAS' aller Speicherbänke N+1 bis N+M funktionsmäßig miteinander und einem Signal RAS' einer der Speicherbänke 1 bis N gekoppelt sind.

3. System nach Anspruch 1, **dadurch gekennzeichnet, dass**
- die zusätzlichen Speicherbänke N+1 bis N+M in Gruppen unterteilt sind;
- innerhalb jeder Gruppe die Signale RAS' der Speicherbänke funktionsmäßig miteinander gekoppelt sind und
- die gekoppelten Signale RAS' jeder Gruppe funktionsmäßig mit einem der Signale RAS' der Speicherbänke 1 bis N gekoppelt sind, vorausgesetzt, dass die Signale RAS' der genannten Gruppen auf verschiedene Speicherbänke 1 bis N gegeben werden.

4. System nach einem der vorstehenden Ansprüche, **dadurch gekennzeichnet, dass** N den Wert Zwei hat.

5. System nach einem der vorstehenden Ansprüche, **dadurch gekennzeichnet, dass** N den Wert Zwei hat und M den Wert Zwei hat, in welchem Fall das Signal RAS' der dritten Speicherbank mit dem Signal RAS' der ersten Speicherbank gekoppelt ist und das Signal RAS' der vierten Speicherbank mit dem Signal RAS' der zweiten Speicherbank gekoppelt ist.

## Revendications

1. Système comprenant :
- un microprocesseur (20) ;
- N + M banques de mémoire DRAM (22, 23, 24) dans lesquelles N et M sont des entiers plus grands que zéro, lesdites banques de mémoire comprenant une entrée de signal RAS' pour rafraîchir la banque de mémoire, une entrée de signal OE' pour empêcher de façon temporaire la récupération de données en provenance de la banque de mémoire et une entrée de signal WE' pour empêcher de façon temporaire l'écriture de données dans la banque de mémoire ;
- une unité de commande de DRAM (26) et un multiplexeur d'adresses (27) pour commander les banques de mémoire DRAM ; et
- en plus du microprocesseur, des seconds moyens (21) qui utilisent la mémoire DRAM, lesdits moyens étant conçus pour s'occuper du rafraîchissement de la mémoire DRAM du système et pour supporter N banques de mémoire au maximum ;
**caractérisé en ce que**
- les signaux RAS' des banques de mémoire N + 1 à N + M sont reliés de manière opérationnelle aux signaux RAS' des banques de mémoire 1 à N afin de permettre le rafraîchissement des banques de mémoire N + 1 à N + M en relation avec le rafraîchissement des banques de mémoire 1 à N, et **en ce que**
- l'unité de commande de DRAM est prévue pour empêcher le fonctionnement des banques de mémoire N + M avec les signaux OE' et WE' des banques de mémoire DRAM tandis que les seconds moyens utilisant la mémoire DRAM font usage de la mémoire DRAM.

2. Système selon la revendication 1, **caractérisé en ce que** les signaux RAS' de toutes les banques de mémoire N + 1 à N + M sont reliés de manière opérationnelle les uns aux autres et à un signal RAS' de l'une des banques de mémoire 1 à N.

3. Système selon la revendication 1, **caractérisé en ce que** :
- les banques de mémoire N + 1 à N + M sont divisées en groupes,
- à l'intérieur de chaque groupe, les signaux RAS' des banques de mémoire sont reliés de manière opérationnelle les uns aux autres, et
- les signaux RAS' reliés de chaque groupe sont reliés de manière opérationnelle à l'un des signaux RAS' des banques de mémoire 1 à N, pourvu que les signaux RAS' desdits groupes soient reliés à des banques de mémoire différentes 1 à N.

4. Système selon l'une quelconque des revendications précédentes, **caractérisé en ce que** N est égal à deux.

5. Système selon l'une quelconque des revendications précédentes, **caractérisé en ce que** N est égal à deux et M est égal à deux, auquel cas le signal RAS' de la troisième banque de mémoire est relié au signal RAS' de la première banque de mémoire, et le signal RAS' de la quatrième banque de mémoire est relié au signal RAS' de la deuxième banque de mémoire.
